# FASCICULE DE BREVET EUROPEEN

(11) **EP 4 634 619 B1**
(45) Date de publication et mention de la délivrance du brevet: **20.05.2026**
(21) Numéro de dépôt: 24716380.1
(22) Date de dépôt: 02.04.2024
(51) Int. Cl.: G01D 5/14, G01D 18/00

(54) **SYSTÈME DE DÉTECTION D'UN MICRO-DÉPLACEMENT**
SYSTEM ZUR ERFASSUNG EINER MIKROBEWEGUNG
SYSTEM FOR DETECTING A MICROMOVEMENT

(30) Priorité: 14.04.2023 FR 2303764
(43) Date de publication de la demande: 22.10.2025
(73) Titulaire: PA.COTTE SA, 1009 Pully (CH)
(72) Inventeur: THOMAS, Fabien, 44980 SAINTE LUCE SUR LOIRE (FR); RABAUD, Sébastien, 44980 SAINTE LUCE SUR LOIRE (FR)
(74) Mandataire: reuteler & cie SA
(86) Numéro de dépôt international: PCT/EP2024/058938
(87) Numéro de publication internationale: WO 2024/213441

(56) Documents cités:
- WO-A1-2017/007641
- WO-A2-2010/053707
- US-A1- 2017 082 461

## Description

### Domaine de l'invention

Le domaine de l'invention est celui de la conception et de la fabrication de systèmes électroniques et plus spécifiquement de systèmes d'ouvrants motorisés.

Le domaine de l'invention est également celui de la conception et de la fabrication de contenants tels que des bagages.

### Etat de la technique

L'ouverture et la fermeture d'un ouvrant par rapport à un dormant sur lequel est monté mobile l'ouvrant peuvent être réalisées de manière purement manuelle telle que cela est traditionnel dans le domaine de la bagagerie, ou alors être réalisées de manière motorisée tel que cela peut être constaté dans d'autres domaines techniques.

Pour une conception ou l'actionnement est uniquement manuel, l'ouvrant est classiquement couplé au dormant à l'aide d'une charnière.

Dans ce cas, l'ouvrant est ouvert ou fermé en étant simplement pivoté autour d'un axe de pivotement formé par la charnière.

Selon une conception classique d'un mécanisme d'ouverture d'un bagage à actionnement manuel, le mécanisme n'exerce pas ou peu de résistance à l'encontre d'une manipulation de l'ouvrant par un utilisateur.

Ainsi, un utilisateur peut aisément rabattre l'ouvrant sur le dormant, faisant passer de la sorte l'ouvrant d'une position ouverte à une position rabattue sur le dormant.

Les mécanismes avec un actionnement manuel sont généralement pourvus de moyens de verrouillage de l'ouvrant dans sa position rabattue sur le dormant.

De tels moyens de verrouillage peuvent être constitués par :
- une encoche présentée par l'ouvrant sur une de ses tranches ;
- un cran présenté par le dormant et destiné à s'engager dans l'encoche dans la position rabattue de l'ouvrant ;
- un actionneur couplé au cran pour permettre de le rétracter de l'encoche lors de l'ouverture de l'ouvrant.

Le cran peut présenter un biseau et des moyens de rappel dans une position en saillie. De cette manière, quand l'ouvrant est rabattu il exerce une pression sur le cran et le repousse, autorisant de la sorte le passage de l'ouvrant dans sa position rabattue. Arrivé dans sa position rabattue, l'encoche se retrouve en vis-à-vis du cran qui, sous l'effet des moyens de rappel, s'engage dans l'encoche et verrouille l'ouvrant dans sa position rabattue.

S'agissant des mécanismes motorisés, l'emploi de moteurs électriques permet d'ouvrir et de fermer un ouvrant par rapport à un dormant sans nécessiter l'intervention d'une personne. Dans ce cas, il n'est alors pas nécessaire d'ouvrir ou de refermer manuellement l'ouvrant, le moteur étant apte à réaliser à lui seul l'ouverture ou la fermeture de l'ouvrant.

Ces différents types de mécanismes présentent chacun leurs spécificités et leurs avantages intrinsèques. Le mécanisme purement manuel et mécanique permet une fermeture de l'ouvrant réalisable de manière naturelle et intuitive pour un utilisateur. Le mécanisme motorisé offre quant à lui une fermeture de l'ouvrant automatique ne nécessitant pas d'intervention directe de l'utilisateur.

Il peut être ainsi recherché à concilier les avantages d'un mécanisme d'ouverture classique avec un actionnement manuel à ceux d'un mécanisme motorisé.

Dans le document de brevet publié sous le numéro FR3107294, il a été proposé un système de fermeture mettant en oeuvre des capteurs permettant de déterminer si une force est appliquée sur l'ouvrant pour déclencher une fermeture de l'ouvrant. De manière plus générale, ce système peut être appliqué à la détection d'un micro-déplacement d'un organe par rapport à un corps. US2017/082461 A1 divulgue un autre système connu.

Par ce système, un utilisateur peut déclencher une fermeture automatique du couvercle en initiant manuellement cette fermeture. Cet utilisateur n'a en effet pas de besoin d'accompagner complétement la fermeture du couvercle du fait d'un moteur électrique qui prend le relai du mouvement initié manuellement. La fermeture automatique est alors initiée de manière particulièrement intuitive.

Pour améliorer la détection de l'application d'une force sur l'ouvrant, et notamment éviter qu'une force appliquée sur l'extrémité de l'ouvrant distale de la charnière ne soit pas détectée, ou mal évaluée, le document de brevet propose d'employer des capteurs à effet Hall associés à des aimants.

En pratique, cette amélioration de la détection n'est pas satisfaisante à cause d'un nombre trop important de déclenchements non intentionnels de la fermeture de l'ouvrant. Une diminution de la sensibilité des capteurs à effet Hall permet de constater une diminution des déclenchements non intentionnels au détriment de la réactivité du système.

### Objectifs de l'invention

L'invention a pour objectif de palier à ces inconvénients de l'art antérieur.

Plus précisément, l'invention a pour objectif de proposer un système électronique permettant de déclencher une action prédéterminée dès l'application d'une force sur un organe mobile par rapport à un corps, et évitant des déclenchements non intentionnels.

L'invention a également pour objectif de fournir un tel système qui présente une réactivité non dégradée, notamment par rapport à celle du système d'ouvrant selon l'art antérieur avec une sensibilité diminuée des capteurs à effet Hall.

### Exposé de l'invention

Ces objectifs, ainsi que d'autres qui apparaitront par la suite, sont atteints grâce à l'invention qui a pour objet un système électronique comprenant :
- un corps ;
- un organe mobile par rapport au corps entre une position fermée dans laquelle il est rabattu vers le corps, et au moins une position ouverte dans lequel il est éloigné du corps par rapport à la position fermée ;
- au moins un couple d'éléments de détection d'un micro-déplacement de l'organe lors de l'application d'un effort par un utilisateur entraînant un déplacement de l'organe depuis l'une de ses positions en direction d'une autre de ses positions, le couple d'éléments comprenant un capteur à effet Hall porté par l'un de l'organe et du corps, et un aimant porté par l'autre de l'organe et du corps en regard du capteur à effet Hall ;
- une unité électronique paramétrée pour piloter une action prédéterminée si le micro-déplacement engendre une valeur du champ magnétique capté par le capteur à effet Hall atteignant ou dépassant une première borne par rapport à une valeur de référence du champ magnétique,
caractérisé en ce que l'unité électronique est paramétrée avec un cycle de calibration configuré pour calibrer la première borne comprenant:
- une étape de détermination de la valeur de référence du champ magnétique à l'aide du capteur à effet Hall dans une position stabilisée de l'ouvrant par rapport au dormant ;
- une étape de paramétrage de la première borne en fonction du champ magnétique de référence.

Grâce au système selon l'invention, le déclenchement de l'action prédéterminée se réalise uniquement suite à l'application d'un effort suffisant sur l'organe.

En effet, le système selon l'invention permet d'éviter que des mesures de type « faux-positif » au niveau du capteur à effet Hall n'entraînent l'action prédéterminée de manière inopportune.

Plus précisément, il a été remarqué que de telles mesures du type « faux-positif » correspondaient à des mesures dépassant un seuil programmé de déclenchement de l'action prédéterminée, en l'absence de l'application d'un effort sur l'organe.

La cause de telles mesures a été identifiée comme résultant des conditions environnementales dans lesquelles le ou les capteurs à effet Hall sont situées.

Par exemple, l'ouverture d'une fenêtre dans une pièce peut produire des variations (température, pression, humidité, ...) susceptibles de modifier la précision du ou des capteurs à effet Hall, et de provoquer des mesures du type « faux-positif ».

En conséquence, la réalisation d'un cycle de calibration permet de prendre en compte ces conditions environnementales pour définir une première borne adaptée à la manière dont réagi le capteur à effet Hall dans ces conditions. Des essais ont permis de constater une baisse drastique des mesures de type « faux-positif », voire une absence de telles mesures.

De plus, une telle première borne adaptée évite l'usage d'une borne programmée et prédéterminée à une valeur tellement éloignée qu'elle dégraderait la réactivité du système.

Préférentiellement, l'étape de détermination de la valeur de référence du champ magnétique comprend :
- une sous-étape de réalisation d'une pluralité de mesures du champ magnétique capté par le capteur à effet Hall ;
- une sous-étape de calcul d'une moyenne de la pluralité de mesures pour calculer la valeur de référence du champ magnétique.

La valeur de référence du champ magnétique prend alors plus de temps à être déterminée, toutefois elle est alors plus précise. De plus, il est également évité qu'une valeur peu représentative de la moyenne réelle soit utilisée pour paramétrer la première borne.

Selon une solution préférée, l'étape de paramétrage de la première borne comprend une sous-étape d'application d'un premier facteur de pondération à la valeur de référence du champ magnétique de référence pour calculer la première borne.

De cette manière, le paramétrage est réalisé simplement, et le premier facteur de pondération peut être sélectionné au plus juste pour améliorer la réactivité du système.

Selon une variante préférentielle, l'unité électronique est paramétrée pour piloter une autre action prédéterminée si le micro-déplacement engendre une valeur du champ magnétique capté par le capteur à effet Hall atteignant ou dépassant une seconde borne à l'opposé de la première borne par rapport à la valeur de référence du champ magnétique.

Le système permet alors également de piloter une autre action prédéterminée si l'effort appliqué sur l'ouvrant est fait en direction opposé de l'effort capable de déclencher la première action prédéterminée.

En d'autres termes, un rapprochement de l'organe vers le corps peut entraîner une première action prédéterminée, tandis qu'un éloignement de l'organe depuis le corps peut entraîner une deuxième action prédéterminée.

Avantageusement, le cycle de calibration est également configuré pour calibrer la seconde borne en comprenant en outre une étape de paramétrage de la seconde borne en fonction de la valeur de référence du champ magnétique.

Selon une solution préférée, l'étape de paramétrage de la seconde borne comprend une sous-étape d'application d'un deuxième facteur de pondération à la valeur de référence du champ magnétique pour calculer la seconde borne .

Le paramétrage est réalisé simplement, et le deuxième facteur de pondération peut être sélectionné au plus juste pour améliorer la réactivité du système.

Selon une caractéristique préférentielle, l'unité électronique est paramétrée pour déclencher le cycle de calibration après la détermination d'une stabilisation de la position de de l'organe par le biais d'un capteur de position, ledit capteur de position étant préférentiellement formé par le capteur à effet Hall.

De cette manière, une calibration est réalisée dès que l'organe a atteint une position stabilisée, et cette calibration permet de prendre en compte les conditions environnementales du ou des capteurs à effet Hall suite à un déplacement de l'organe.

Selon une autre caractéristique préférentielle, le système comprend un capteur de température ambiante, l'unité électronique étant paramétrée pour déclencher le cycle de calibration après la détermination d'une variation d'une température captée par le biais du capteur de température.

La température ambiante étant un paramètre dont la variation a produit de manière marquée des variations de la capacité d'un capteur à effet Hall à mesurer précisément un champ magnétique, alors la réalisation d'une calibration dès la détection d'une variation de la température évite la mesure de « faux-positif » induite par ce paramètre.

Selon un mode de réalisation préférentiel :
- le corps est un dormant ;
- l'organe est un ouvrant mobile par rapport au dormant entre la position fermée dans laquelle il est rabattu sur le dormant, et au moins une position ouverte ;
- au moins un actionneur motorisant l'ouverture et la fermeture de l'ouvrant ;
- l'unité électronique est paramétrée pour piloter l'actionneur pour qu'il entraîne la fermeture de l'ouvrant si le micro-déplacement engendre une valeur du champ magnétique capté par le capteur à effet Hall égale ou supérieure à la première borne.

Le système est alors un système d'ouverture motorisé et il est ainsi possible de déclencher de manière particulièrement réactive la fermeture de l'ouvrant, tout en évitant une fermeture entraînée par une mesure de type « faux-positif ».

L'invention a également pour objet un contenant comprenant un caisson et un couvercle, caractérisé en ce qu'il met en oeuvre le système d'ouverture décrit précédemment, le caisson formant le dormant, et le couvercle formant l'ouvrant.

Un tel contenant présente un système d'ouverture particulièrement qualitatif et attrayant du fait de sa réactivité pour déclencher le déplacement du couvercle.

L'invention a encore pour objet un procédé de calibration d'une première borne de déclenchement d'une action prédéterminée d'un système électronique décrit précédemment, caractérisé en ce qu'il comprend :
- une étape de détection de la stabilisation de la position de l'organe par rapport au corps ;
- une étape de détermination d'une valeur de référence du champ magnétique à l'aide du capteur à effet Hall ;
- une première étape de paramétrage de la première borne en fonction de la valeur de référence du champ magnétique.

### Figures

D'autres caractéristiques et avantages de l'invention apparaîtront plus clairement à la lecture de la description suivante de différents modes de réalisation préférentiels de l'invention, donnés à titre d'exemples illustratifs et non limitatifs, et des dessins annexés parmi lesquels :
- [Fig. 1] est une représentation schématique de côté d'un contenant selon un premier mode de réalisation de l'invention, comprenant un caisson et un couvercle, pour lequel une cinématique de fermeture du couvercle est représentée ;
- [Fig. 2] est une représentation schématique de côté d'un mécanisme d'ouverture du contenant selon le premier mode de réalisation de l'invention ;
- [Fig. 3] est une vue en perspective d'une partie d'un contenant ouvert selon un deuxième mode de réalisation de l'invention ;
- [Fig. 4] est une représentation schématique selon une vue en coupe de côté d'une partie d'un contenant, selon le deuxième mode de réalisation, avec son couvercle dans une position fermée ;
- [Fig. 5] une représentation schématique selon une vue de côté en coupe d'une partie d'un contenant, selon le deuxième mode de réalisation, avec son couvercle dans une position d'ouverture intermédiaire ;
- [Fig. 6] une représentation schématique selon une vue de côté en coupe d'une partie d'un contenant, selon le deuxième mode de réalisation, avec son couvercle dans une position d'ouverture maximale ;
- [Fig. 7] la figure 7 est un ordinogramme illustrant un procédé de calibration selon l'invention.

### Description détaillée de l'invention

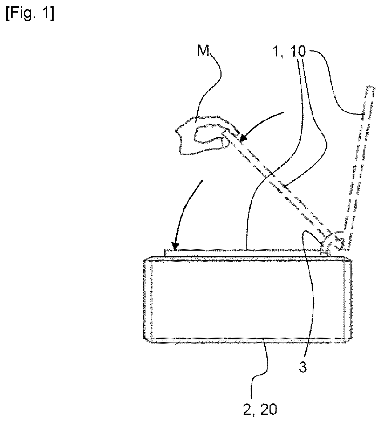

Un contenant selon l'invention est illustré par les figures 1 à 6.

Le contenant comprend un caisson 20 et un couvercle 10 monté mobile sur le caisson 20.

Ce contenant met en oeuvre un système électronique selon l'invention, et plus spécifiquement un système d'ouverture.

Tel que cela apparaît par la suite, le système met en oeuvre un procédé de calibration selon l'invention.

Le système d'ouverture comprend un dormant 2, et un ouvrant 1 monté mobile par rapport au dormant 2.

Le caisson 20 forme le dormant 2, et le couvercle 10 forme l'ouvrant 1.

En d'autres termes, l'ouvrant 1 est monté mobile par rapport au dormant 2.

En référence aux figures 1 à 6, l'ouvrant 1 est mobile entre une position fermée et au moins une position ouverte.

Dans sa position fermée, l'ouvrant 1 est rabattu sur le dormant 2.

Plus généralement, le système électronique comprend un corps et un organe mobile par rapport au corps. Selon les présents modes de réalisation, le corps est le dormant, tandis que l'organe est l'ouvrant. Toutefois, il est envisageable que le corps soit un support et que l'organe soit un bouton mobile par rapport au support.

L'organe est ainsi mobile par rapport au corps entre une position dite « position fermée » dans laquelle il est rabattu vers le corps, et au moins une position dite « position ouverte » dans lequel il est éloigné du corps par rapport à la position fermée.

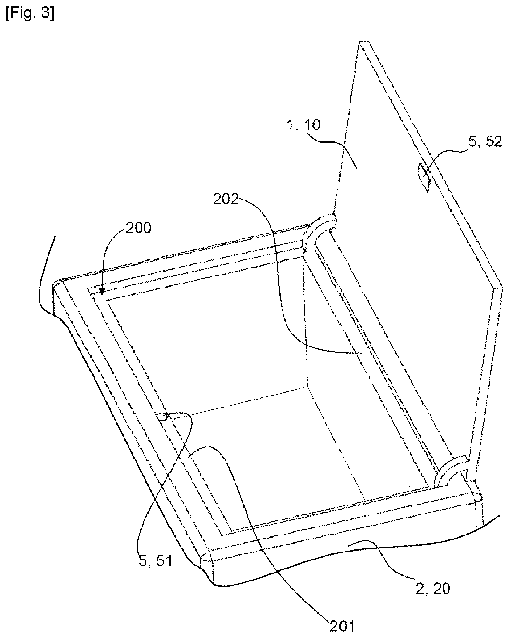

Selon la figure 3, et tel que cela est détaillé par la suite, le dormant 2 présente un cadre 200. Ce cadre 200 délimite un emplacement qui est occupé par l'ouvrant 1 dans sa position fermée F.

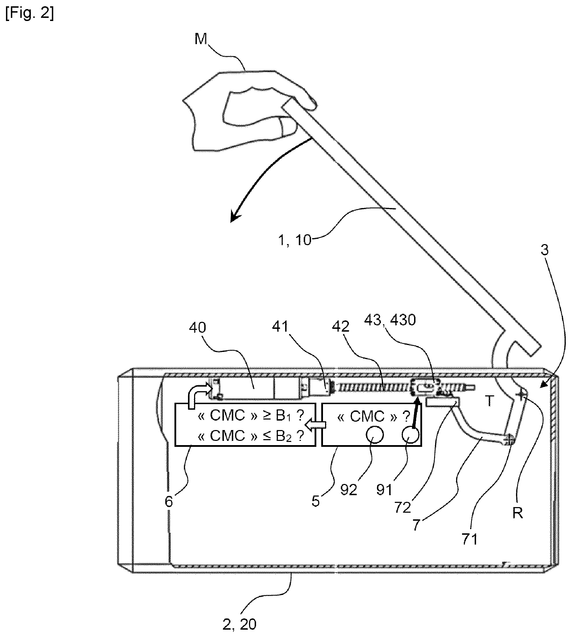

En référence au premier mode de réalisation illustré par les figures 1 et 2, l'ouvrant 1 est monté mobile en rotation uniquement sur le dormant 2.

En référence au deuxième mode de réalisation illustré par les figures 3 à 6, l'ouvrant 1 présente une cinématique d'ouverture ou de fermeture plus complexe par rapport au premier mode de réalisation.

Plus précisément, l'ouvrant 1 est :
- mobile en rotation par rapport au dormant 2 entre une position d'ouverture maximale et une position d'ouverture intermédiaire ;
- mobile en translation par rapport au dormant 2 entre la position d'ouverture intermédiaire et la position fermée.

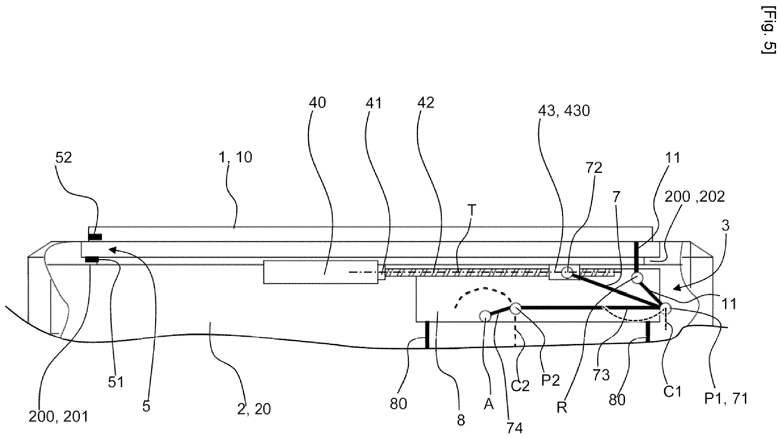

La position d'ouverture intermédiaire, illustrée par la figure 5, correspond notamment à une position dans laquelle l'ouvrant 1 est suffisamment écarté de sa position fermée, par le biais d'une translation, pour qu'il puisse être saisi par un utilisateur du contenant.

Bien entendu, le contenant selon le premier mode de réalisation peut également présenter un ouvrant 1 qui, tout en étant uniquement monté mobile en rotation, présente une position d'ouverture intermédiaire comparable à celle du deuxième mode de réalisation.

Entre sa position d'ouverture intermédiaire et sa position d'ouverture maximale, l'ouvrant 1 présente une pluralité d'autres positions d'ouvertures dans lesquelles il peut être stabilisé.

Pour permettre la mobilité de l'ouvrant 1 sur le dormant 2, le système comprend une charnière 3 entre l'ouvrant 1 et le dormant 2.

La charnière 3 est décrite plus précisément par la suite en référence aux deux modes de réalisation.

Le système comprend également au moins un couple d'éléments de détection 5 d'un micro-déplacement de l'organe lors de l'application d'un effort par un utilisateur entraînant un micro-déplacement de l'organe depuis l'une de ses positions en direction d'une autre de ses positions ;
- une unité électronique 6.

Le système comprend encore, selon les présents modes de réalisation au moins un actionneur 40, qui est en l'occurrence un moteur électrique, l'unité électronique 6 étant couplée à l'actionneur.

Tel que cela est détaillé par la suite, le couple d'éléments de détection 5 permet de déterminer qu'un utilisateur applique un effort sur l'organe, ou en d'autres termes sur l'ouvrant 1.

Selon le présent mode de réalisation le couple d'éléments de détection 5 d'un micro-déplacement de l'ouvrant 1 permet de déterminer qu'une force est exercée sur l'ouvrant 1 pour entraîner son déplacement depuis l'une de ses positions ouvertes intermédiaires en direction de sa position d'ouverture maximale, ou depuis l'une de ses positions ouvertes en direction de sa position fermée.

Le ou les moteurs électriques 40 motorisent l'ouverture et la fermeture de l'ouvrant 1. A cet effet, le ou les moteurs électriques 40 coopèrent avec la charnière 3.

Selon les présents modes de réalisation, le système comprend notamment deux actionneurs, qui sont des moteurs électriques.

Ces moteurs électriques sont des moteurs à courant continu à balais. Chaque moteur électrique est en outre équipé d'un réducteur 41 et produit un mouvement de rotation.

La charnière comprend plus précisément deux sous-ensembles dont un sous-ensemble gauche et un sous-ensemble droit coopérant chacun avec l'un des deux moteurs électrique.

Bien entendu, il est envisageable que la charnière 3 comprenne deux sous-ensembles dont un seul coopère avec un unique actionneur 40.

Le système comprend également des moyens d'arrêt du moteur électrique.

Ces moyens d'arrêt du moteur électrique sont configurés pour interrompre une fermeture de l'ouvrant 1 par le moteur électrique suite à la détection d'une résistance allant à l'encontre de la fermeture de l'ouvrant.

Le ou les moteurs électriques peuvent entraîner en mobilité l'ouvrant 1 sur le dormant 2 à l'aide de la conception décrite ci-après du couplage du ou des moteurs électriques à la charnière 3.

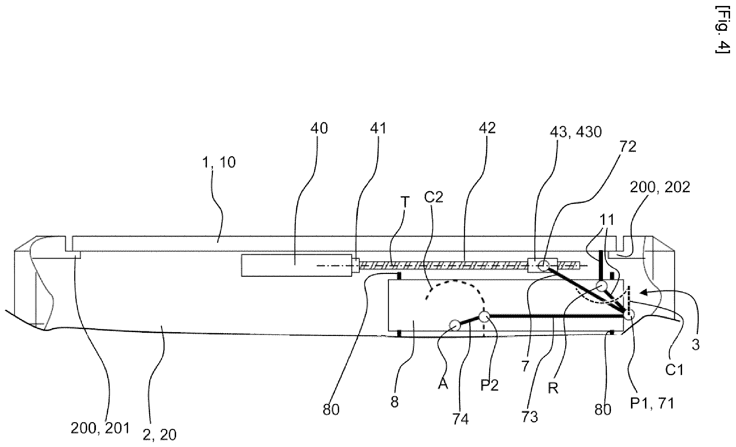

En référence à la figure 2, et aux figures 4 à 6, la charnière 3 comprend un mécanisme de conversion d'un mouvement de rotation en un mouvement de translation.

Ce mécanisme de conversion comprend un organe intermédiaire 43 qui est mobile en translation sous l'effet du moteur électrique 40.

En référence à la figure 2 :
- le moteur électrique 40 et le réducteur 41 permettent d'entraîner en rotation une vis 42 ;
- le mécanisme de conversion correspond à une vis à billes, l'organe intermédiaire 43 étant plus particulièrement un écrou 430.

L'écrou 430 est couplé sur la vis 42.

L'organe intermédiaire 43, et plus particulièrement l'écrou 430, est mobile le long d'un axe de translation T qui est formé par l'axe d'extension de la vis 42.

Selon le premier mode de réalisation illustré par la figure 2, dans lequel l'ouvrant 1 est uniquement monté mobile en rotation sur le dormant 2, la charnière 3 comprend également un premier bras de transmission 7 qui couple l'organe intermédiaire 43 à l'ouvrant 1. Plus particulièrement, le premier bras de transmission 7 couple l'organe intermédiaire 43 au couvercle 10.

Tel qu'illustré par la figure 2, le premier bras de transmission 7 est plus précisément couplé par une première extrémité à l'ouvrant 1 sur un premier point de pivot 71 qui est excentré d'un premier axe de rotation R de l'ouvrant 1. Le premier bras de transmission 7 est également couplé par une seconde extrémité, opposée à la première extrémité, à l'organe intermédiaire 43 sur un second point de pivot 72.

Le dispositif est configuré de manière à ce qu'une translation de l'organe intermédiaire 43 selon un premier sens entraîne l'ouverture de l'ouvrant 1, et qu'une translation de l'organe intermédiaire 43 selon un second sens entraîne une fermeture de l'ouvrant 1.

Selon le deuxième mode de réalisation illustré par les figures 4 à 6, dans lequel l'ouvrant 1 présente une mobilité en translation entre sa position d'ouverture intermédiaire et sa position fermée, la charnière 3 présente les mêmes caractéristiques que celle du premier mode de réalisation, et comprend également au moins un bâti mobile 8 monté mobile en translation sur au moins un élément de guidage 80 en translation présenté par le dormant 2.

Plus précisément, la charnière 3 comprend deux bâtis mobiles 8, soit un bâti mobile 8 pour chaque sous-ensemble.

L'ouvrant 1 est alors monté mobile en rotation sur le ou les bâtis mobiles 8.

Des chemins de came complémentaires, dont un premier chemin de came C1 et un deuxième chemin de came C2 présentés par le dormant 2 et/ou par les bâtis mobiles 8, permettent de transformer le mouvement de translation de l'organe intermédiaire 43 le long de l'axe de translation T soit en un mouvement de translation de l'ouvrant 1, soit en un mouvement de rotation de l'ouvrant 1.

Plus spécifiquement, selon le mode de réalisation illustré par les figures 4 à 6, le bâti mobile 8 porte le premier axe de rotation R et un second axe de rotation A ;

De plus, l'ouvrant 1 comprend une partie fixe 11 s'étendant à l'intérieur du caisson 20 dans la position fermée de l'ouvrant 1. Cette partie fixe est solidaire d'un plan principal de l'ouvrant 1.

La partie fixe 11 coopère avec le bâti mobile 8 pour permettre à l'ouvrant 1 d'être mobile en rotation autour du premier axe de rotation R.

Selon le présent mode de réalisation, la charnière 3 comprend :
- une première came P1 mobile dans le premier chemin de came C1, la première came P1 étant également le premier point de pivot 71 auquel est couplé le premier bras de transmission 7 ;
- une deuxième came P2 mobile dans le deuxième chemin de came C2 ;
- un deuxième bras de transmission 73 couplé à la première came P1 à une première extrémité et à la deuxième came P2 à une deuxième extrémité ;
- un troisième bras de transmission 74 couplé à la deuxième came P2 à une extrémité et au second axe de rotation A à une deuxième extrémité.

Tel que cela est illustré par les figures 4 et 5, la translation de l'organe intermédiaire 43 le long d'une première section de la vis 42 entraîne une translation du bâti mobile 8 entre une position basse et une position haute, et ainsi une translation de l'ouvrant 1 entre sa position fermée et sa position d'ouverture intermédiaire.

Cette translation du bâti mobile 8 est permise grâce au premier chemin de came C1 et au deuxième chemin de came C2 qui présentent chacun une portion rectiligne. La translation de l'organe intermédiaire 43 le long de la première section de la vis 42 entraîne, grâce au premier bras de transmission 7, au deuxième bras de transmission 73, au troisième bras de transmission 74, ainsi qu'aux contraintes exercées par les chemins de cames, le déplacement de la première came P1 et de la deuxième came P2 uniquement le long des portions rectilignes de leur chemin de came respectives.

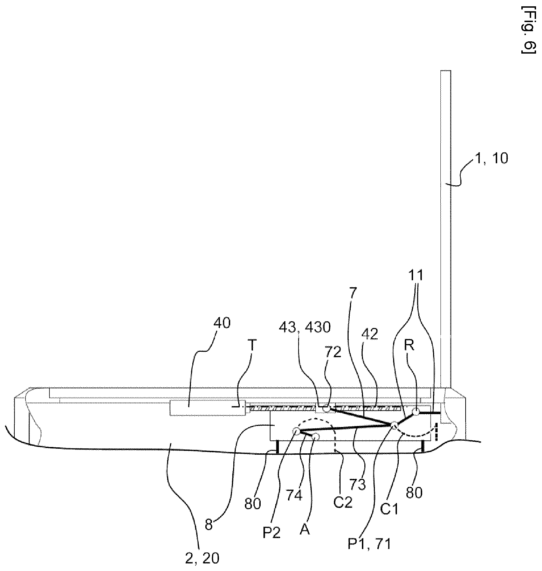

Tel que cela est illustré par les figures 5 et 6, la translation de l'organe intermédiaire 43 le long d'une seconde section de la vis 42 entraîne une rotation de l'ouvrant 1 autour du premier axe de rotation R, alors en position haute, qui est situé sur le ou les bâtis mobiles 8, et ainsi une rotation de l'ouvrant 1 par rapport au dormant 2.

Cette rotation de l'ouvrant 1 est permise grâce au premier chemin de came C1 et au deuxième chemin de came C2 qui présentent chacun une portion courbe qui prolonge leur portion rectiligne. La translation de l'organe intermédiaire 43 le long de la deuxième section de la vis 42 entraîne quant à elle, grâce au premier bras de transmission 7, au deuxième bras de transmission 73, au troisième bras de transmission 74, ainsi qu'aux contraintes exercées par les chemins de cames, le déplacement de la première came P1 et de la deuxième came P2 uniquement le long des portions courbes de leur chemin de came respectives. La première came P1 et la deuxième came P2 sont alors plus spécifiquement entraînées en rotation autour respectivement du premier axe de rotation R et du second axe de rotation A.

Tel qu'expliqué précédemment, le ou les couples d'éléments de détection 5 permettent de déterminer qu'une force est exercée sur l'organe, et ainsi sur l'ouvrant 1, pour déclencher une action prédéterminée, en l'occurrence la fermeture ou l'ouverture motorisée de l'ouvrant 1.

Le ou chaque couple d'éléments comprend :
- un capteur à effet Hall 51 porté par l'un de l'ouvrant 1 et du dormant 2 ;
- un aimant 52 porté par l'autre du dormant 2 et de l'ouvrant 1.

En effet, en référence aux figures 3 et 5, un capteur à effet Hall 51 est porté par le dormant 2, et un aimant 52 est porté par l'ouvrant 1. Dans la position d'ouverture intermédiaire de l'ouvrant 1, comme illustré par la figure 5, l'aimant 52 est positionné en regard du capteur à effet Hall 51.

Ce capteur à effet Hall 51 est positionné à proximité immédiate du cadre 200.

Plus précisément, le capteur à effet Hall 51 est positionné à proximité immédiate d'un bord avant 201 du cadre 200, opposé à un bord arrière 202 du cadre 200, la charnière 3 étant positionnée dans le dormant 2 du côté du bord arrière 202 du cadre 200.

Un tel capteur à effet Hall 51 permet de mesurer une variation de champ magnétique et, ainsi, de détecter la position de l'aimant 52 par rapport au capteur à effet Hall 51 pour de déterminer la position de l'ouvrant 1 par rapport au bord avant 201 du cadre 200.

L'unité électronique 6 est alors paramétrée pour corréler une variation du signal du capteur à effet Hall 51 engendrée par l'application d'un effort sur l'ouvrant 1 dans sa position d'ouverture intermédiaire au micro-déplacement.

Selon d'autres modes de réalisation envisageables, le système peut comporter une pluralité d'aimants 52 pour le ou chaque capteur à effet Hall 51.

Dans ce cas, la position et l'intensité des champs magnétiques de chaque aimant 52 peuvent être conçues pour que le capteur effet Hall puisse mesurer différentes intensité de champ magnétique en différentes position stabilisées de l'ouvrant 1.

Par exemple, les aimants 52 peuvent être positionnés de manière linéaire avec une alternance de polarité parallèlement à une droite le long de laquelle est situé le capteur à effet Hall 51 lors de l'ouverture ou de la fermeture de l'ouvrant.

A cet effet et de manière complémentaire, le capteur à effet Hall 51 et/ou les aimants peuvent être solidarisés à un bras attaché à l'ouvrant 1 et se déployant lors de l'ouverture de l'ouvrant 1.

Selon encore d'autres modes de réalisation envisageables, le système peut comprendre une pluralité de couples de capteur à effet Hall 51 et d'aimant(s) 52, répartis à différentes positions sur l'ouvrant 1 et le dormant 2.

Il est à noter qu'un positionnement du couple d'élément de détection 5 à l'opposé de la charnière 3 permet d'améliorer la sensibilité du système . En effet, ce positionnement est situé à l'endroit du système où l'amplitude de mouvement est la plus grande, et où l'utilisateur est le plus à même de réaliser un appui.

L'unité électronique est 6 paramétrée pour piloter une action prédéterminée si le micro-déplacement engendre une valeur du champ magnétique capté CMC par le capteur à effet Hall 51 qui atteint ou qui dépasse une première borne B₁ par rapport à une valeur de référence du champ magnétique CMR.

En outre, l'unité électronique 6 est paramétrée pour piloter une autre action prédéterminée si le micro-déplacement engendre une valeur du champ magnétique capté CMC par le capteur à effet Hall 51 qui atteint ou qui dépasse une seconde borne B₂ à l'opposé de la première borne B₁ par rapport à la valeur de référence du champ magnétique CMR.

Selon un exemple d'application la première action prédéterminée peut correspondre à l'allumage d'une lumière, tandis que l'autre action prédéterminée correspond à l'extinction de cette lumière.

Plus spécifiquement selon les présents mode de réalisation, l'unité électronique 6 est paramétrée pour piloter l'actionneur 40 pour qu'il entraîne :
- la fermeture de l'ouvrant 1 si le micro-déplacement engendre une valeur du champ magnétique capté CMC par le capteur à effet Hall 51 égale ou supérieure à la première borne B₁ ;
- l'ouverture complète de l'ouvrant 1 depuis une position ouverte intermédiaire si le micro-déplacement engendre une valeur du champ magnétique capté CMC par le capteur à effet Hall 51 égale ou inférieure à la seconde borne B₂.

Selon l'invention, l'unité électronique 6 est paramétrée avec un cycle de calibration configuré pour calibrer la première borne B₁.

Selon le présent mode de réalisation, le cycle de calibration est également configuré pour réaliser une calibration de la seconde borne B₂.

Ainsi, le cycle de calibration comprend :
- une étape de détermination d'une valeur de référence du champ magnétique CMR à l'aide du capteur à effet Hall 51 dans une position stabilisée de l'organe par rapport au corps, et plus spécifiquement de l'ouvrant 1 par rapport au dormant 2 ;
- une étape de paramétrage de la première borne B₁ en fonction de la valeur de référence du champ magnétique CMR.
- une étape de paramétrage de la seconde borne B₂ en fonction de la valeur de référence du champ magnétique CMR.

Pour déterminer si l'ouvrant 1 est dans une position stabilisée, le système comprend un capteur de position qui peut par exemple être avantageusement formé par le capteur à effet Hall 51.

Tel que cela est détaillé par la suite, dans le cas où le capteur de position est formé par le capteur à effet Hall, la détermination d'une position stabilisée est corrélée avec la stabilisation de mesures issues du capteur à effet Hall et une moyenne glissante de ces mesures.

Le cycle de calibration comprend ainsi préalablement une étape de détection de la stabilisation de l'organe par rapport au corps.

Selon le présent mode de réalisation le capteur de position est formé par un capteur distinct 91 qui détermine la position d'un organe de la charnière, dit « organe témoin ».

En l'occurrence, l'organe de transmission 43 forme l'organe témoin.

Plus particulièrement, le capteur distinct 91 permet de déterminer la position de l'organe intermédiaire 43, et plus précisément de l'écrou 430, le long de son axe de translation T. La position de l'ouvrant 1 par rapport au dormant 2 est alors corrélée à la position de l'organe intermédiaire 43 le long de l'axe de translation T.

L'évolution de la position de l'organe intermédiaire 43 le long de l'axe de translation T permet notamment de déterminer l'évolution de la position de l'ouvrant 1. Une stabilisation de la position de l'organe intermédiaire 43 correspond alors à une stabilisation de la position de l'ouvrant 1.

Dans une version simplifiée, l'étape de détermination de la valeur de référence du champ magnétique CMR peut consister en un unique relevé du champ magnétique par le capteur à effet Hall 51.

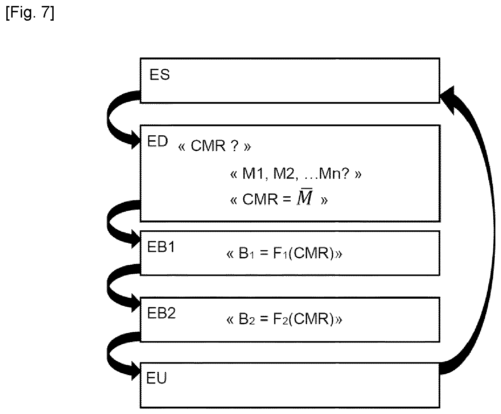

En référence à la figure 7, l'étape de détermination de la valeur de référence du champ magnétique CMR comprend :
- une sous-étape de réalisation d'une pluralité de mesures (M₁, M₂, ... Mₙ) du champ magnétique capté par le capteur à effet Hall 51 ;
- une sous-étape de calcul d'une moyenne de la pluralité de mesures (M₁, M₂, ... Mₙ) pour obtenir la valeur de référence du champ magnétique CMR.

La pluralité de mesures peut sélectionnée dans la gamme comprise entre 4 et 40 mesures, avantageusement entre 8 et 25 mesures, typiquement entre 10 et 14 mesures. La fréquence d'échantillonnage peut également être adaptée. L'adaptation du nombre de mesures réalisées et de la fréquence d'échantillonnage peut notamment être sélectionnée pour optimiser la réactivité du système.

Il peut par exemple être réalisé dix mesures à 200 Hz (5ms d'intervalle entre chaque mesure).

Cette pluralité de mesures permet ensuite la détermination d'une moyenne.

L'unité électronique 6 peut être programmée pour effectuer une surveillance de l'écart type des mesures et, en cas de détection d'un écart trop important, relancer la sous-étape de réalisation d'une pluralité de mesures. Ainsi, la sous-étape est relancée si l'écart entre la valeur de mesure la plus faible et la valeur de mesure la plus élevée de la pluralité de mesures (M₁, M₂, ... Mₙ) dépasse une limite fixée (par exemple comprise entre 2mT et 50mt, typiquement entre 5mT et 25mT, avantageusement à 10 mT). En conséquence, la moyenne est considérée valide lorsque l'écart est inférieur à la limite.

L'étape de paramétrage de la première borne B₁ comprend une sous-étape d'application d'un premier facteur de pondération F₁ à la valeur de référence du champ magnétique CMR pour calculer la première borne B₁.

L'étape de paramétrage de la seconde borne B₂ comprend une sous-étape d'application d'un deuxième facteur de pondération F₂ à la valeur de référence du champ magnétique CMR pour calculer la seconde borne B₂.

De manière générale, tel que cela est représenté sur la figure 7, ces paramétrages sont représentés par les équations suivantes : B₁ = F₁(CMR), et B₂ = F₂(CMR).

Selon une première variante, le premier facteur de pondération F₁ et le deuxième facteur de pondération F₂ sont des facteurs de multiplication.

Ceci correspond aux équations suivantes : B₁ = CMR*F₁, et B₂ = CMR*F₂.

Par exemple, le premier facteur de pondération F₁ peut correspondre à 1,1 et deuxième facteur de pondération F₂ peut correspondre à 0,9.

Ainsi, une valeur de référence du champ magnétique CMR à 4 mT donne une première borne B₁ à 4,4 mT et une seconde borne B₂ à 3,6 mT.

Dans une seconde variante, la pondération au sens de l'invention est un coefficient soustrait ou ajouté à la valeur de référence du champ magnétique CMR de sorte à obtenir respectivement la première borne B₁, et la seconde borne B₂. Le ou les coefficients permettent d'avoir des bornes symétriques ou non par rapport à la valeur de référence du champ magnétique CMR. Par exemple les première et seconde bornes B₁, B₂ sont distantes de 128 mT de la valeur de référence du champ magnétique CMR.

Ceci correspond aux équations suivantes : B₁ = CMR+F₁, et B₂ = CMR-F₂.

Ces étapes de paramétrage se terminent par une sous-étape d'enregistrement des bornes.

Selon un mode alternatif de réalisation de l'invention, la valeur de référence du champ magnétique CMR est une moyenne dite moyenne glissante. Celle-ci est calculée sur une pluralité de mesures (M₁, M₂, ... Mₙ) stockée dans une mémoire tampon du type premier entré, premier sortie également connu sous l'acronyme « FIFO » (acronyme anglophone de « First In, First Out »). Une mesure supplémentaire Mₙ₊₁ est obtenue et soustraite à la moyenne glissante obtenue dont la valeur absolue définit un écart. Si cet écart est inférieur ou égale à un seuil limite, la moyenne glissante est considérée stabilisée. Dans le cas contraire, lorsque l'écart est supérieur à ce seuil limite, la mesure supplémentaire Mₙ₊₁ est poussée dans la mémoire tampon de laquelle est éjectée la mesure M₁ de sorte à calculer une mise à jour de la moyenne glissante et reprendre l'étape de comparaison. Ainsi, de nouvelles mesures supplémentaires sont effectuées, renouvelant progressivement la pluralité de mesures stockée dans la mémoire tampon, jusqu'à obtenir la moyenne qui glisse jusqu'à être stabilisée.

Le calcul de la moyenne glissante des mesures du capteur à effet Hall décrit précédemment peut également être mis en oeuvre pour déterminer l'arrivée dans une position stabilisée de l'organe par rapport au corps, tel que cela est évoqué précédemment.

Selon un mode de réalisation particulier, de la pluralité de mesures (M₁, M₂, ...Mₙ) acquises sont extraites les valeurs minimale Mₘᵢₙ et maximale Mₘₐₓ pour déterminer l'écart d'amplitude de la pluralité de mesures (M₁, M₂, ...Mₙ). Cet écart d'amplitude est calculé en soustrayant la valeur minimale Mₘᵢₙ à la valeur maximale Mₘₐₓ précédemment extraites. Si l'écart d'amplitude ainsi déterminé est inférieur au seuil limite fixé, alors on calcul la moyenne de la pluralité de mesures (M₁, M₂, ...Mₙ), qui fixe la valeur de référence du champ magnétique CMR. Dans le cas où l'écart d'amplitude est supérieur au seuil limite fixé, on reprend la procédure par l'acquisition d'une nouvelle pluralité de mesures (M₁, M₂, ...Mₙ) qui écrase la précédente pluralité de mesures, afin de calculer un nouvel écart d'amplitude et poursuivre les étapes précédemment décrites jusqu'à obtenir la valeur de référence du champ magnétique CMR.

L'unité électronique 6 est paramétrée pour déclencher périodiquement le cycle de calibration. De cette manière, la première borne et la seconde borne enregistrées dans l'unité électronique 6 sont mises à jour régulièrement.

Le capteur distinct 91 est également utilisé pour déclencher le cycle de calibration.

En effet, l'unité électronique 6 est paramétrée pour surveiller la position de l'ouvrant 1 par rapport au dormant 2 et détecter une stabilisation de la position de l'ouvrant 1. Cette détection est réalisée par le biais du capteur distinct 91.

Suite à la détection d'une stabilisation de la position de l'ouvrant 1 dans une position prédéterminée, l'unité électronique 6 est paramétrée pour déclencher le cycle de calibration.

De manière similaire, une variation de température ambiante ou de l'hygrométrie ambiante peut déclencher le cycle de calibration.

En effet, le système comprend un capteur de température 92 ambiante, et l'unité électronique 6 est paramétrée pour surveiller la température par le biais du capteur de température 92 et détecter une variation de température. Dans ce cas, l'unité électronique 6 est paramétrée pour déclencher le cycle de calibration.

Le cycle de calibration précédemment décrit correspond à un procédé de calibration d'au moins une borne de déclenchement d'une action prédéterminée, et en l'occurrence de deux bornes dont l'une déclenche une action prédéterminée qui est la fermeture de l'ouvrant, et l'autre déclenche une autre action prédéterminée qui est l'ouverture de l'ouvrant.

Le procédé comprend également les différentes étapes du cycle de calibration précédemment détaillées.

Pour résumer, et en référence à la figure 7, ce procédé comprend :
- une étape de détection de la stabilisation ES de la position de l'organe par rapport au corps ;
- une étape de détermination ED d'une valeur de référence du champ magnétique CMR à l'aide du capteur à effet Hall 51 ;
- une première étape de paramétrage EB1 de la première borne B₁ en fonction de la valeur de référence du champ magnétique CMR ;
- une deuxième étape de paramétrage EB2 de la seconde borne B₂ en fonction de la valeur de référence du champ magnétique CMR ;
- une étape de surveillance EU de paramètres du système pour déclencher un nouveau cycle de calibration au besoin.

L'étape de détection de la stabilisation ES peut mettre en oeuvre :
- une sous-étape de réalisation d'une pluralité de mesures M1, M2, ...Mn du champ magnétique capté par le capteur à effet Hall 51 ;
- une sous-étape de calcul d'une moyenne de la pluralité de mesures M1, M2, ...Mn pour déterminer, grâce au maintien d'une nouvelle mesure Mn+1 dans la moyenne, une stabilisation de la position de l'organe par rapport au corps.

Le système et le procédé selon l'invention permettent de déclencher des actions prédéterminées, c'est-à-dire notamment une fermeture, et une ouverture pour le mode de réalisation précédemment décrits, de manière particulièrement réactive dès que l'organe est manipulé, et sans permettre de déclenchement non désiré d'une action prédéterminée.

## Revendications

1. Système électronique destiné à la détection d'un micro-déplacement d'un organe mobile par rapport à un corps, le système comprenant :
- un corps ;
- un organe mobile par rapport au corps entre une position fermée dans laquelle il est rabattu vers le corps, et au moins une position ouverte dans lequel il est éloigné du corps par rapport à la position fermée ;
- au moins un couple d'éléments de détection (5) d'un micro-déplacement de l'organe lors de l'application d'un effort par un utilisateur entraînant un micro-déplacement de l'organe depuis l'une de ses positions en direction d'une autre de ses positions, le couple d'éléments comprenant un capteur à effet Hall (51) porté par l'un de l'organe et du corps, et un aimant (52) porté par l'autre de l'organe et du corps en regard du capteur à effet Hall (51) ;
- une unité électronique (6) paramétrée pour piloter une action prédéterminée si le micro-déplacement engendre une valeur du champ magnétique capté (CMC) par le capteur à effet Hall (51) atteignant ou dépassant une première borne (B₁) par rapport à une valeur de référence du champ magnétique (CMR),
**caractérisé en ce que** l'unité électronique (6) est paramétrée avec un cycle de calibration configuré pour calibrer la première borne (B₁) comprenant:
- une étape de détermination de la valeur de référence du champ magnétique (CMR) à l'aide du capteur à effet Hall (51) dans une position stabilisée de l'organe par rapport au corps ;
- une étape de paramétrage de la première borne (B₁) en fonction du champ magnétique de référence (CMR),
l'unité électronique (6) étant paramétrée pour détecter une stabilisation de la position de l'organe par rapport au corps, et déclencher le cycle de calibration après la détermination d'une stabilisation de la position de l'organe.

2. Système selon la revendication précédente, **caractérisé en ce que** l'étape de détermination de la valeur de référence du champ magnétique (CMR) comprend :
- une sous-étape de réalisation d'une pluralité de mesures (M₁, M₂, ...Mₙ) du champ magnétique capté par le capteur à effet Hall (51) ;
- une sous-étape de calcul d'une moyenne de la pluralité de mesures (M₁, M₂, ...Mₙ) pour calculer la valeur de référence du champ magnétique (CMR).

3. Système selon l'une quelconque des revendications précédentes, **caractérisé en ce que** l'étape de paramétrage de la première borne (B₁) comprend une sous-étape d'application d'un premier facteur de pondération (F₁) à la valeur de référence du champ magnétique (CMR) pour calculer la première borne (B₁).

4. Système selon l'une quelconque des revendications précédentes, **caractérisé en ce que** l'unité électronique (6) est paramétrée pour piloter une autre action prédéterminée si le micro-déplacement engendre une valeur du champ magnétique capté (CMC) par le capteur à effet Hall (51) atteignant ou dépassant une seconde borne (B₂) à l'opposé de la première borne (B₁) par rapport à la valeur de référence du champ magnétique (CMR).

5. Système selon la revendication précédente, **caractérisé en ce que** le cycle de calibration est également configuré pour calibrer la seconde borne (B₂) en comprenant en outre une étape de paramétrage de la seconde borne (B₂) en fonction de la valeur de référence du champ magnétique (CMR).

6. Système selon la revendication précédente, **caractérisé en ce que** l'étape de paramétrage de la seconde borne (B₂) comprend une sous-étape d'application d'un deuxième facteur de pondération (F₂) à la valeur de référence du champ magnétique (CMR) pour calculer la seconde borne (B₂).

7. Système selon l'une quelconque des revendications précédentes, **caractérisé en ce que** la détermination d'une stabilisation de la position de l'organe est réalisée par le biais d'un capteur de position, ledit capteur de position étant préférentiellement formé par le capteur à effet Hall (51).

8. Système selon l'une quelconque des revendications précédentes, **caractérisé en ce qu'**il comprend un capteur de température (92) ambiante, l'unité électronique (6) étant paramétrée pour déclencher le cycle de calibration après la détermination d'une variation d'une température captée par le biais du capteur de température (92).

9. Système selon l'une quelconque des revendication précédentes, **caractérisé en ce que**:
- le corps est un dormant (2) ;
- l'organe est un ouvrant (1) mobile par rapport au dormant (2) entre la position fermée dans laquelle il est rabattu sur le dormant (2), et au moins une position ouverte ;
- au moins un actionneur (40) motorisant l'ouverture et la fermeture de l'ouvrant (1) ;
- l'unité électronique (6) est paramétrée pour piloter l'actionneur (40) pour qu'il entraîne la fermeture de l'ouvrant (1) si le micro-déplacement engendre une valeur du champ magnétique capté (CMC) par le capteur à effet Hall (51) égale ou supérieure à la première borne (B₁).

10. Système selon la revendication précédente et la revendication 4, **caractérisé en ce que** l'unité électronique (6) est paramétrée pour piloter l'actionneur (40) pour qu'il entraîne l'ouverture complète de l'ouvrant (1) depuis une position ouverte intermédiaire si le micro-déplacement engendre une valeur du champ magnétique capté par le capteur à effet Hall (51) égale ou inférieure à la seconde borne (B₂).

11. Contenant comprenant un caisson et un couvercle, **caractérisé en ce qu'**il met en oeuvre le système selon l'une quelconque des revendications 9 et 10, le caisson (20) formant le dormant (2), et le couvercle (10) formant l'ouvrant (1).

12. Procédé de calibration d'une première borne (B₁) de déclenchement d'une action prédéterminée d'un système selon l'une quelconque des revendications 1 à 10, **caractérisé en ce qu'**il comprend :
- une étape de détection de la stabilisation de la position de l'organe par rapport au corps ;
- une étape de détermination d'une valeur de référence du champ magnétique (CMR) à l'aide du capteur à effet Hall (51)
- une première étape de paramétrage (EB1) de la première borne (B₁) en fonction de la valeur de référence du champ magnétique (CMR).

## Patentansprüche

1. Elektronisches System zum Detektieren einer Mikroverlagerung eines Organs, das im Verhältnis zu einem Körper beweglich ist, wobei das System umfasst:
- einen Körper;
- ein Organ, das im Verhältnis zu dem Körper zwischen einer geschlossenen Position, in der es zu dem Körper hin eingeklappt ist, und mindestens einer offenen Position, in der es von dem Körper entfernt ist, im Verhältnis zu der geschlossenen Position beweglich ist;
- mindestens ein Paar von Elementen (5) zum Detektieren einer Mikroverlagerung des Organs bei der Ausübung einer Kraft durch einen Benutzer, die eine Mikroverlagerung des Organs von einer seiner Position in Richtung auf eine andere seiner Positionen bewirkt, wobei das Paar von Elementen einen Hall-Sensor (51), der von einem von dem Organ und dem Körper getragen wird, und einen Magneten (52), der von dem anderen von dem Organ und dem Körper dem Hall-Sensor (51) gegenüber getragen wird, umfasst;
- eine elektronische Einheit (6), die dazu parametriert ist, eine vorbestimmte Aktion anzusteuern, falls die Mikroverlagerung einen Wert des von dem Hall-Sensor (51) aufgenommenen Magnetfeldes (CMC) erzeugt, der eine erste Grenze (B₁) im Verhältnis zu einem Referenzwert des Magnetfeldes (CMR) erreicht oder überschreitet,
**dadurch gekennzeichnet, dass** die elektronische Einheit (6) mit einem Kalibrierzyklus parametriert wird, der dazu konfiguriert ist, die erste Grenze (B₁) zu kalibrieren, umfassend:
- einen Schritt zum Bestimmen des Referenzwertes des Magnetfeldes (CMR) anhand des Hall-Sensors (51) in einer stabilisierten Position des Organs im Verhältnis zum Körper;
- einen Schritt zum Parametrieren der ersten Grenze (B₁) in Abhängigkeit von dem Referenzmagnetfeld (CMR),
wobei die elektronische Einheit (6) dazu parametriert ist, eine Stabilisierung der Position des Organs im Verhältnis zum Körper zu detektieren und den Kalibrierzyklus nach der Bestimmung einer Stabilisierung der Position des Organs auszulösen.

2. System nach dem vorhergehenden Anspruch, **dadurch gekennzeichnet, dass** der Schritt zum Bestimmen des Referenzwerts des Magnetfeldes (CMR) umfasst:
- einen Teilschritt zum Ausführen einer Vielzahl von Messungen (M₁, M₂, ... Mₙ) des Magnetfeldes, das von dem Hall-Sensor (51) aufgenommen wird;
- einen Teilschritt zum Berechnen eines Mittelwertes der Vielzahl von Messungen (M₁, M₂, ... Mₙ), um den Referenzwert des Magnetfeldes (CMR) zu berechnen.

3. System nach einem der vorhergehenden Ansprüche, **dadurch gekennzeichnet, dass** der Schritt zum Parametrierens der ersten Grenze (B₁) einen Teilschritt zum Anwenden eines ersten Gewichtungsfaktors (F₁) auf den Referenzwert des Magnetfeldes (CMR) umfasst, um die erste Grenze (B₁) zu berechnen.

4. System nach einem der vorhergehenden Ansprüche, **dadurch gekennzeichnet, dass** die elektronische Einheit (6) dazu parametriert ist, eine andere vorbestimmte Aktion anzusteuern, wenn die Mikroverlagerung einen Wert des von dem Hall-Sensor (51) aufgenommenen Magnetfeldes (CMC) erzeugt, der eine zweite Grenze (B₂), die der ersten Grenze (B₁) entgegengesetzt ist, im Verhältnis zu dem Referenzwert des Magnetfeldes (CMR) erreicht oder überschreitet.

5. System nach dem vorhergehenden Anspruch, **dadurch gekennzeichnet, dass** der Kalibrierzyklus auch dazu konfiguriert ist, die zweite Grenze (B₂) zu kalibrieren, indem er ferner einen Schritt zum Parametrierens der zweiten Grenze (B₂) in Abhängigkeit von dem Referenzwert des Magnetfeldes (CMR) umfasst.

6. System nach dem vorhergehenden Anspruch, **dadurch gekennzeichnet, dass** der Schritt zum Parametrierens der zweiten Grenze (B₂) einen Teilschritt zum Anwenden eines zweiten Gewichtungsfaktors (F₂) auf den Referenzwert des Magnetfeldes (CMR) umfasst, um die zweite Grenze (B₂) zu berechnen.

7. System nach einem der vorhergehenden Ansprüche, **dadurch gekennzeichnet, dass** das Bestimmen einer Stabilisierung der Position des Organs anhand eines Positionssensors erfolgt, wobei der Positionssensor bevorzugt durch den Hall-Sensor (51) gebildet wird.

8. System nach einem der vorhergehenden Ansprüche, **dadurch gekennzeichnet, dass** es einen Umgebungstemperatursensor (92) umfasst, wobei die elektronische Einheit (6) dazu parametriert ist, den Kalibrierzyklus nach der Bestimmung einer Variation einer Temperatur, die über den Temperatursensor (92) aufgenommen wird, auszulösen.

9. System nach einem der vorhergehenden Ansprüche, **dadurch gekennzeichnet, dass**:
- der Körper eine Einfassung (2) ist;
- das Organ ein Öffnungselement (1) ist, das im Verhältnis zu der Einfassung (2) zwischen der geschlossenen Position, in der es auf die Einfassung (2) eingeklappt ist, und mindestens einer offenen Position beweglich ist;
- mindestens ein Stellglied (40), welches das Öffnen und das Schließen des Öffnungselements (1) motorisiert;
- die elektronische Einheit (6) dazu parametriert ist, das Stellglied (40) anzusteuern, damit es das Schließen des Öffnungselements (1) bewirkt, falls die Mikroverlagerung einen Wert des von dem Hall-Sensor (51) aufgenommenen Magnetfeldes (CMC) erzeugt, der gleich oder größer als die erste Grenze (B₁) ist.

10. System nach dem vorhergehenden Anspruch und Anspruch 4, **dadurch gekennzeichnet, dass** die elektronische Einheit (6) dazu parametriert ist, das Stellglied (40) anzusteuern, damit es die vollständige Öffnung des Öffnungselements (1) von einer offenen Zwischenposition aus bewirkt, falls die Mikroverlagerung einen Wert des von dem Hall-Sensor (51) aufgenommenen Magnetfeldes erzeugt, der gleich oder kleiner als die zweite Grenze (B₂) ist.

11. Behälter, umfassend einen Kasten und einen Deckel, **dadurch gekennzeichnet, dass** er das System nach einem der Ansprüche 9 und 10 umsetzt, wobei der Kasten (20) die Einfassung (2) bildet und der Deckel (10) das Öffnungselement (1) bildet.

12. Verfahren zum Kalibrieren einer ersten Grenze (B₁) zum Auslösen einer vorbestimmten Aktion eines Systems nach einem der Ansprüche 1 bis 10, **dadurch gekennzeichnet, dass** es umfasst:
- einen Schritt zum Detektieren der Stabilisierung der Position des Organs im Verhältnis zum Körper;
- einen Schritt zum Bestimmen eines Referenzwertes des Magnetfeldes (CMR) anhand des Hall-Sensors (51),
einen ersten Schritt zum Parametrierens (EB1) der ersten Grenze (B₁) in Abhängigkeit von dem Referenzwert des Magnetfeldes (CMR).

## Claims

1. Electronic system intended for detecting a micro-movement of a member movable with respect to a body, the system comprising:
- a body;
- a member movable with respect to the body between a closed position in which it is folded down toward the body, and at least one open position in which it is further away from the body with respect to the closed position;
- at least one pair of elements (5) for detecting a micro-movement of the member upon the application of a force by a user causing a micro-movement of the member from one of its positions in the direction of another of its positions, the pair of elements comprising a Hall-effect sensor (51), carried by one out of the member and the body, and a magnet (52), carried by the other out of the member and the body, facing the Hall-effect sensor (51);
- an electronic unit (6) parameterized to control a predetermined action if the micro-movement gives rise to a value of the magnetic field (CMC) sensed by the Hall-effect sensor (51) reaching or exceeding a first bound (B₁) with respect to a reference value of the magnetic field (CMR),
**characterized in that** the electronic unit (6) is parameterized with a calibration cycle configured to calibrate the first bound (B₁) comprising:
- a step of determining the reference value of the magnetic field (CMR) using the Hall-effect sensor (51) in a stabilized position of the member with respect to the body;
- a step of parameterizing the first bound (B₁) as a function of the reference magnetic field (CMR), the electronic unit (6) being parameterized to detect a stabilization of the position of the member with respect to the body, and to trigger the calibration cycle after determining the stabilization of the position of the member.

2. The system as claimed in the preceding claim, **characterized in that** the step of determining the reference value of the magnetic field (CMR) comprises:
- a sub-step of taking a plurality of measurements (M₁, M₂, ...M₃) of the magnetic field sensed by the Hall-effect sensor (51);
- a sub-step of computing an average of the plurality of measurements (M₁, M₂, ...M₃) to compute the reference value of the magnetic field (CMR).

3. The system as claimed in any of the preceding claims, **characterized in that** the step of parameterizing the first bound (B₁) comprises a sub-step of applying a first weighting factor (F₁) to the reference value of the magnetic field (CMR) to compute the first bound (B₁).

4. The system as claimed in any of the preceding claims, **characterized in that** the electronic unit (6) is parameterized to control another predetermined action if the micro-movement gives rise to a value of the magnetic field (CMC) sensed by the Hall-effect sensor (51) reaching or exceeding a second bound (B₂) opposite to the first bound (B₁) with respect to the reference value of the magnetic field (CMR).

5. The system as claimed in the preceding claim, **characterized in that** the calibration cycle is also configured to calibrate the second bound (B₂) further comprising a step of parameterizing the second bound (B₂) as a function of the reference value of the magnetic field (CMR).

6. The system as claimed in the preceding claim, **characterized in that** the step of parameterizing the second bound (B₂) comprises a sub-step of applying a second weighting factor (F₂) to the reference value of the magnetic field (CMR) to compute the second bound (B₂).

7. The system as claimed in any of the preceding claims, **characterized in that** the determining of the stabilization of the position of the member is carried out by way of a position sensor, said position sensor being preferably formed by the Hall-effect sensor (51).

8. The system as claimed in any of the preceding claims, **characterized in that** it comprises an ambient temperature sensor (92), the electronic unit (6) being parameterized to trigger the calibration cycle after determining a variation in a temperature sensed by way of the temperature sensor (92).

9. The system as claimed in any of the preceding claims, **characterized in that**:
- the body is a frame part (2);
- the member is an opening part (1) movable with respect to the frame part (2) between the closed position in which it is folded down onto the frame part (2), and at least one open position;
- at least one actuator (40) driving the opening and closing of the opening part (1) by a motor;
- the electronic unit (6) is parameterized to control the actuator (40) so that it drives the closing of the opening part (1) if the micro-movement gives rise to a value of the magnetic field (CMC) sensed by the Hall-effect sensor (51) equal to or greater than the first bound (B₁).

10. The system as claimed in the preceding claim and claim 4, **characterized in that** the electronic unit (6) is parameterized to control the actuator (40) so that it drives the complete opening of the opening part (1) from an intermediate open position if the micro-movement gives rise to a value of the magnetic field sensed by the Hall-effect sensor (51) equal to or less than the second bound (B₂).

11. A container comprising a box and a cover, **characterized in that** it implements the system as claimed in any of claims 9 and 10, the box (20) forming the frame part (2), and the cover (10) forming the opening part (1).

12. A method for calibrating a first bound (B₁) for triggering a predetermined action of a system as claimed in any of claims 1 to 10, **characterized in that** it comprises:
- a step of detecting the stabilization of the position of the member with respect to the body;
- a step of determining a reference value of the magnetic field (CMR) using the Hall-effect sensor (51)
- a first step of parameterizing (EB1) the first bound (B₁) as a function of the reference value of the magnetic field (CMR).
